(19) Europäisches Patentamt / European Patent Office / Office européen des brevets

(11) **EP 3 340 004 B1**

(12) **FASCICULE DE BREVET EUROPEEN**

(45) Date de publication et mention de la délivrance du brevet:
**06.07.2022 Bulletin 2022/27**

(21) Numéro de dépôt: **17209206.6**

(22) Date de dépôt: **21.12.2017**

(51) Classification Internationale des Brevets (IPC):
**G05D 23/19** *(2006.01)* **G06F 30/13** *(2020.01)*

(52) Classification Coopérative des Brevets (CPC):
**G05D 23/1917; G06F 30/13**

(54) **PROCEDE DE DETERMINATION DE LA CAPACITE DE DELESTAGE D'UN BATIMENT EXPLOITANT L'INERTIE THERMIQUE, PROCEDE DE DELESTAGE ASSOCIE ET SYSTEME METTANT EN OEUVRE LESDITS PROCEDES**

VERFAHREN ZUR BESTIMMUNG DER ENTLASTUNGSFÄHIGKEIT EINES GEBÄUDES DURCH AUSNUTZUNG DER THERMISCHEN TRÄGHEIT, ENTSPRECHENDES ENTLASTUNGSVERFAHREN UND SYSTEM ZUR UMSETZUNG DIESER VERFAHREN

METHOD FOR DETERMINING THE LOAD-SHEDDING CAPABILITY OF A BUILDING USING THERMAL INERTIA, ASSOCIATED LOAD-SHEDDING METHOD AND SYSTEM USING SAID METHODS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.12.2016 FR 1663218**

(43) Date de publication de la demande:
**27.06.2018 Bulletin 2018/26**

(73) Titulaire: **Commissariat à l'Energie Atomique et aux Energies Alternatives
75015 Paris (FR)**

(72) Inventeurs:
• **VALLEE, Mathieu
73230 SAINT-ALBAN-LEYSSE (FR)**

• **BAVIERE, Roland
38000 GRENOBLE (FR)**

(74) Mandataire: **Cabinet Camus Lebkiri
25 rue de Maubeuge
75009 Paris (FR)**

(56) Documents cités:
**WO-A1-2011/117356 FR-A1- 2 638 864
FR-A1- 3 001 068**

• **PEDER BACHER ET AL: "Identifying suitable models for the heat dynamics of buildings", ENERGY AND BUILDINGS, vol. 43, no. 7, 1 juillet 2011 (2011-07-01), pages 1511-1522, XP055415322, CH ISSN: 0378-7788, DOI: 10.1016/j.enbuild.2011.02.005**

**Description**

**DOMAINE TECHNIQUE DE L'INVENTION**

Le domaine technique de l'invention est celui des systèmes de chauffage des bâtiments. La présente invention concerne un procédé de détermination de la capacité de délestage d'un bâtiment ainsi qu'un procédé de délestage d'un bâtiment. La présente invention concerne également un système de chauffage mettant en oeuvre un procédé de détermination de la capacité de délestage d'un bâtiment ou un procédé de délestage d'un bâtiment selon l'invention.

**ARRIERE-PLAN TECHNOLOGIQUE DE L'INVENTION**

Le chauffage d'un bâtiment est en général assuré par un système de chauffage comportant un dispositif de chauffage relié à un circuit de chauffage dans lequel circule un fluide caloporteur, et qui comprend des éléments de tuyauterie et des émetteurs (par exemple des radiateurs). L'apport de chaleur est fourni par le dispositif de chauffage qui prend en général la forme d'une chaudière, d'une pompe à chaleur ou d'une connexion à un réseau de chaleur. Dans la suite, sauf mention contraire, les puissances sont exprimées en Watt, les énergies en Joule et les températures en degré Celsius.

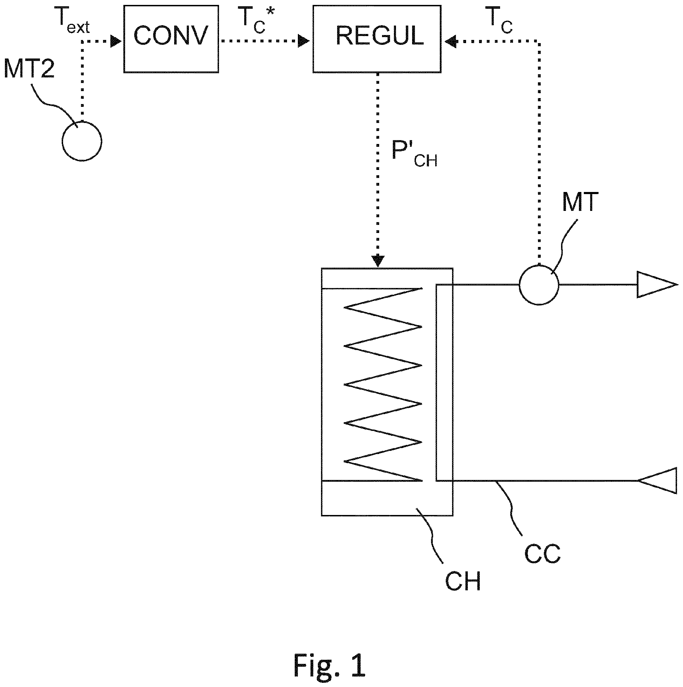

Un exemple de système de chauffage d'un bâtiment est illustré à la figure 1. Le système de chauffage comprend un dispositif de chauffage CH (par exemple une chaudière à gaz), un circuit de chauffage CC dans lequel circule un fluide caloporteur et un dispositif de régulation REGUL. Le circuit de chauffage CC dans lequel circule le fluide caloporteur comprend un capteur de température MT mesurant la température $T_c$ du fluide en sortie du dispositif de chauffage CH (autrement dit, en entrée du circuit de chauffage) circulant dans le circuit de chauffage CC, la température ainsi mesurée étant envoyée au dispositif de régulation REGUL. Le système de chauffage comprend en outre un capteur de température extérieur MT2, la température mesurée étant convertie en consigne de température $T_c^*$ par un moyen de conversion CONV laquelle est envoyée au dispositif de régulation REGUL. Le dispositif de régulation REGUL envoie alors une valeur de commande à l'actionneur en charge de moduler la puissance $P_{ch}$ du dispositif de chauffage en fonction de la température $T_c$ mesurée à l'entrée du circuit de chauffage CC et de la température de consigne $T_c^*$ établie par le moyen de conversion CONV en fonction de la température extérieur $T_{ext}$.

Dans l'exemple précédent, la régulation du système de chauffage est effectuée par le régulateur. Cependant, cette dernière peut également être réalisée par l'intermédiaire de régulateurs terminaux qui régulent la puissance échangée au niveau de chaque émetteur en fonction d'une température de confort dans la pièce dans laquelle il se trouve, voire une combinaison des deux méthodes de régulation précédentes. La puissance $P_{ch}$ ainsi régulée permet de maintenir dans le bâtiment une température $T_{int}$ aussi proche que possible d'une température de consigne $T_{int}^*$. La puissance $P_{ch}$ requise par le système de chauffage pour maintenir l'air du bâtiment à une température conforme à la température de consigne $T_{int}^*$ varie en fonction de différents paramètres, par exemple les conditions météorologiques, la structure du bâtiment (isolation, capacité thermique notamment), des habitudes des occupants (immeuble d'habitation ou de bureau notamment), etc.

Au cours du temps, la puissance requise par ledit système de chauffage présente donc des variations importantes ce qui n'est pas sans poser de problème. En particulier dans le cas d'un système de chauffage relié à un réseau de chaleur, ces variations se répercutent directement sur le réseau de chaleur ce qui peut entraîner de forts pics de consommation. Pour répondre à ces pics de consommation, les opérateurs de réseaux de chaleur doivent dimensionner les installations de manière à pouvoir fournir la puissance maximale requise, ce qui représente de lourds investissements. De plus, les générateurs utilisés en période de pointe sont généralement des générateurs fonctionnant à base de combustibles fossiles, plus coûteux et fortement émetteurs de gaz à effet de serre. Des inconvénients de même nature se posent à n'importe quel système de chauffage pour lequel les prix de l'énergie sont variables au cours du temps, car les pics de prix ont lieu généralement en même temps que les pics de consommation.

Afin de limiter ces pics de consommation, un nouveau mode de régulation a été mis au point. Ce dernier fait appel à une réduction contrôlée de la puissance $P_{ch}$ fournie au système de chauffage, ladite réduction étant communément appelée délestage. Dans ce cas de figure, la puissance effectivement fournie $P_{ch}$ est inférieure à la puissance $P_{ch}$ nécessaire au système de chauffage pour maintenir dans le bâtiment une température $T_{int}$ aussi proche que possible de la température de consigne $T_{int}^*$. Lorsque ce mode de régulation est appliqué de manière coordonnée à de nombreux bâtiments, il permet de diminuer voire de supprimer les pics de consommation. Cela se traduit en revanche par une chute des températures $T_{int}$ à l'intérieur des bâtiments lors des périodes de délestage.

Par exemple, le brevet EP 2021696 (A method for optimizing the power usage in a district heating system) décrit un procédé permettant de tirer parti d'une chute de la température afin de réduire les pics de consommations tout en garantissant le confort des consommateurs, c'est-à-dire une chute modérée de la température intérieure $T_{int}$. La limitation de la chute de température est estimée à l'aide d'une constante de temps fonction de l'inertie du bâtiment déterminée a priori, et vérifiée avec des capteurs de température placés à l'intérieur des bâtiments. D'autres méthodes ont également été développées, mais elles ont en commun la nécessité d'installer des capteurs de températures à l'intérieur de chaque bâtiment afin de pouvoir évaluer leur capacité de délestage K, où autrement dit, quel délestage il est possible d'appliquer à un bâtiment sans que la température intérieure $T_{int}$ du bâtiment concerné ne chute en deçà d'une température minimale $T_{int}^{lim}$. On pourra également cité le document Bâcher et al, « Identifying suitable models for the heat dynamics of building », Energy and buildings, vol. 43, n° 7.

Il existe donc un besoin d'une méthode permettant de déterminer la capacité de délestage K d'un bâtiment sans qu'il soit nécessaire de procéder à l'installation de capteurs de température dans les parties communes et/ou les parties privatives dudit bâtiment.

## RESUME DE L'INVENTION

L'invention offre une solution au problème évoqué précédemment, en permettant de déterminer la capacité de délestage d'un bâtiment à partir de la réponse dudit bâtiment à une perturbation du système de chauffage, cette détermination ne nécessitant pas de mesures de la température intérieure et donc l'installation de capteurs de température à l'intérieur dudit bâtiment, que ce soit dans les parties communes ou les parties privatives.

Pour cela, un premier aspect de l'invention concerne un procédé de détermination de la capacité de délestage K d'un bâtiment selon la revendication 1.

Outre les caractéristiques qui viennent d'être évoquées dans le paragraphe précédent, le procédé selon un premier aspect de l'invention peut présenter une ou plusieurs caractéristiques complémentaires parmi les suivantes, considérées individuellement ou selon toutes les combinaisons techniquement possibles.

Avantageusement, le modèle déterminé lors de l'étape de détermination d'un modèle initial de fonctionnement du bâtiment prend en compte la puissance consommée pour la production de l'eau chaude sanitaire.

Ainsi, l'influence de la puissance consommée pour la production de l'eau chaude sanitaire ne fausse pas la capacité de délestage K déterminée au moyen du procédé selon un premier aspect de l'invention.

Avantageusement, le procédé comprend une étape de mise à jour du modèle physique, l'étape de perturbation de la puissance $P_{ch}$ d'alimentation du système de chauffage, l'étape de mesure de la réponse dudit bâtiment à une perturbation, l'étape de détermination des paramètres dudit modèle initial et l'étape de détermination de la capacité de délestage K du bâtiment étant à nouveau mises en oeuvre lors de cette mise à jour.

Ainsi, lorsque le modèle du bâtiment est mis à jour, la capacité de délestage K dudit bâtiment est recalculée.

Un deuxième aspect de l'invention concerne un procédé de délestage d'un bâtiment ledit bâtiment comprenant un système de chauffage alimenté par une puissance $P_{ch}$. Le procédé selon un deuxième aspect de l'invention comprend :

- une étape de mise en œuvre d'un procédé de détermination de la capacité de délestage K dudit bâtiment selon un premier aspect de l'invention ;
- une étape de détermination des consignes de délestage optimales à partir de la capacité de délestage déterminée ;
- une étape de mise en œuvre desdites consignes de délestage par le système de chauffage.

Outre les caractéristiques qui viennent d'être évoquées dans le paragraphe précédent, le procédé selon un deuxième aspect de l'invention peut présenter une ou plusieurs caractéristiques complémentaires parmi les suivantes, considérées individuellement ou selon toutes les combinaisons techniquement possibles.

Avantageusement, le procédé comprend, à l'issue de la deuxième étape de détermination des consignes de délestage optimales, une étape de vérification des consignes de délestage déterminées lors de l'étape de détermination des consignes de délestage.

Avantageusement, l'étape de vérification des consignes de délestage comprend :

- une première sous-étape de simulation de la réponse du bâtiment à partir desdites consignes et du modèle du bâtiment ;
- une deuxième sous-étape de vérification de la conformité de la réponse du bâtiment obtenue ;
- lorsque la réponse n'est pas conforme, une troisième sous-étape de correction desdites consignes.

Ainsi on s'assure que les consignes de délestage respectent bien les critères souhaités et que notamment la température intérieure dans le bâtiment ne tombe pas en dessous d'une valeur seuil prédéterminée.

Un troisième aspect de l'invention concerne un système de chauffage alimenté par une puissance $P_{ch}$. Le système comprend en outre des moyens pour mettre en œuvre un procédé de détermination de la capacité de délestage K d'un bâtiment selon un premier aspect de l'invention ou un procédé de délestage d'un bâtiment selon un deuxième aspect de l'invention.

Un quatrième aspect de l'invention concerne un produit programme d'ordinateur comprenant des instructions qui conduisent le système selon un troisième aspect de l'invention à exécuter les étapes du procédé selon un premier aspect de l'invention ou un deuxième aspect de l'invention.

Un cinquième aspect de l'invention concerne un support lisible par ordinateur, sur lequel est enregistré le programme d'ordinateur selon un quatrième aspect de l'invention.

L'invention et ses différentes applications seront mieux comprises à la lecture de la description qui suit et à l'examen des figures qui l'accompagnent.

## BREVE DESCRIPTION DES FIGURES

Les figures sont présentées à titre indicatif et nullement limitatif de l'invention.

- La figure 1 montre une représentation schématique d'un système de chauffage selon l'état de l'art.
- La figure 2 montre un ordinogramme d'un procédé de détermination de la capacité de délestage K d'un bâtiment selon un premier mode de réalisation d'un premier aspect de l'invention.
- La figure 3 montre une représentation schématique d'un bâtiment dont la capacité de délestage peut être déterminée à l'aide d'un procédé selon un premier aspect de l'invention.
- La figure 4 montre un ordinogramme d'un procédé de détermination de la capacité de délestage K d'un bâtiment selon un deuxième mode de réalisation d'un premier aspect de l'invention.
- La figure 5 montre une évolution des différents paramètres d'un système de chauffage lorsqu'aucune perturbation n'est appliquée.
- La figure 6 montre une évolution des différents paramètres d'un système de chauffage lorsqu'une légère perturbation est appliquée.
- La figure 7 montre une évolution des différents paramètres d'un système de chauffage lorsqu'une forte perturbation est appliquée.
- La figure 8 montre un ordinogramme d'un procédé de délestage d'un bâtiment selon un mode de réalisation d'un deuxième aspect de l'invention.
- La figue 9 montre un système de chauffage selon un premier mode de réalisation d'un troisième aspect de l'invention.
- La figue 10 montre un système de chauffage selon un deuxième mode de réalisation d'un troisième aspect de l'invention.
- La figue 11 montre un système de chauffage selon un troisième mode de réalisation d'un troisième aspect de l'invention.

## DESCRIPTION DETAILLEE D'AU MOINS UN MODE DE REALISATION DE L'INVENTION

Sauf précision contraire, un même élément apparaissant sur des figures différentes présente une référence unique.

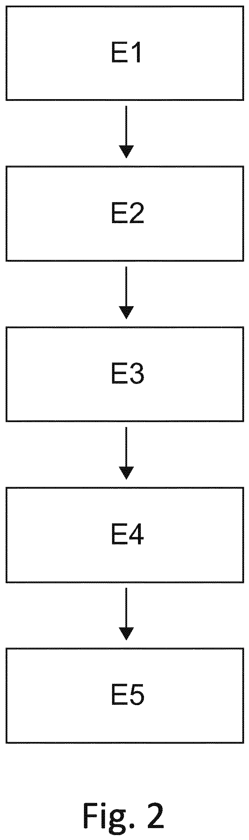

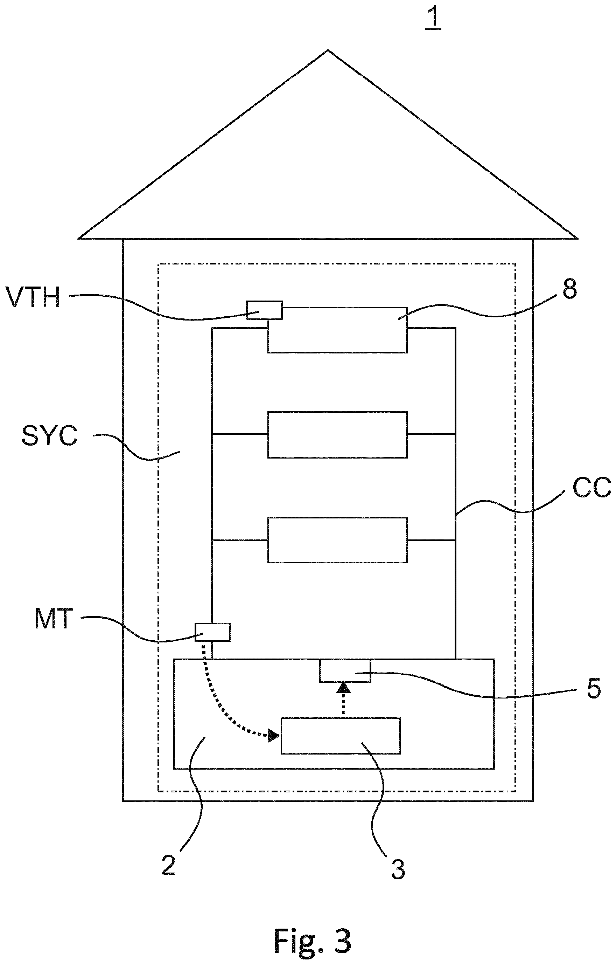

Un premier mode de réalisation illustré à la figure 2 concerne un procédé de détermination de la capacité de délestage K d'un bâtiment selon un premier aspect de l'invention. Un exemple d'un bâtiment dont la capacité de délestage K est susceptible d'être déterminée au moyen d'un procédé selon un premier aspect de l'invention est illustré à la figure 3. Dans cet exemple, le bâtiment comprend un système de chauffage SYC comportant un circuit de chauffage CC. Ledit circuit de chauffage CC est en général parcouru par un fluide caloporteur et parcourt l'ensemble du bâtiment 1 afin de permettre le chauffage de ce dernier. Le système de chauffage SYC est alimenté par une puissance $P_{ch}$. Le circuit de chauffage CC assure le chauffage du bâtiment 1 par l'intermédiaire d'émetteurs thermiques 8, par exemple des radiateurs, lesdits émetteurs thermiques 8 étant eux-mêmes parcourus par le fluide circulant dans le circuit de chauffage CC. La température du fluide circulant dans le circuit de chauffage en entrée dudit circuit est mesure à l'aide d'un capteur de température MT. La température mesurée $T_c$ est transmise à un moyen de commande 3 du système de chauffage SYC qui régule la puissance fournie par le système de chauffage SYC au moyen d'un dispositif de régulation 5. Dans un mode de réalisation, chaque émetteur thermique 8 est en outre connecté à une vanne thermostatique VTH modulant le débit de fluide caloporteur traversant ledit émetteur en fonction d'une consigne locale de température intérieure.

Afin de déterminer la capacité de délestage K du bâtiment, le procédé comprend une étape E1 de détermination d'un modèle initial de fonctionnement du bâtiment caractérisant l'état d'équilibre dudit bâtiment et comprenant des paramètres liés à l'inertie du bâtiment.

Dans un mode de réalisation, le bâtiment est considéré comme un système physique où règne une température moyenne $T_{int}$. Pour ce système, un bilan de puissance instantané s'écrit :

$$I_{bat}\frac{\partial T_{int}}{\partial t} = P_{rad} + P_{ai} - P_{perte} \quad (1)$$

où $I_{bat}$ est l'inertie du bâtiment (en Joule par Kelvin), $P_{rad}$ est la puissance émise par les radiateurs, $P_{ai}$ est la puissance par apport interne et $P_{perte}$ est la puissance perdue par le bâtiment. Autrement dit, la variation dans le temps de la température interne $T_{int}$ du bâtiment est fonction de la puissance émise par les radiateurs $P_{rad}$ de la puissance en apport interne $P_{ai}$, c'est-à-dire la puissance apportée par la présence d'occupants ou par le fonctionnement d'appareils électroménagers, et de la puissance perdue par le bâtiment $P_{perte}$. Le coefficient de proportionnalité $I_{bat}$ entre ces différentes puissances et la variation dans le temps de la température interne $T_{int}$ est appelé inertie du bâtiment.

La puissance perdue par un bâtiment $P_{perte}$ est généralement liée à la différence entre la température interne $T_{int}$ et la température externe du bâtiment $T_{ext}$. Afin de modéliser cette puissance perdue par le bâtiment, dans un mode de réalisation, le modèle suivant est adopté :

$$P_{perte} = UA.(T_{int} - T_{ext}) \quad (2)$$

où UA est le coefficient de perte généralisée du bâtiment.

La puissance par apport interne $P_{ai}$ (présence de personnes, fonctionnement des appareils électroménagers, etc.) peut quant à elle être traitée comme un bruit blanc gaussien de moyenne nulle et de variance faible devant la puissance émise $P_{rad}$ et la puissance perdue $P_{perte}$.

Afin de déterminer la puissance émise par les radiateurs $P_{rad}$ du circuit de chauffage, il convient de s'intéresser au système physique formé par le circuit de chauffage. Le circuit de chauffage est alimenté par une puissance de chauffage $P_{ch}$ afin de délivrer dans le bâtiment la puissance émise par les radiateurs $P_{rad}$. Plus particulièrement, la puissance des radiateurs $P_{rad}$ provient de la mise en circulation d'un fluide qui en entrée de circuit de chauffage a une température $T_c$. De la même manière qu'avec la température interne $T_{int}$ du bâtiment, il est possible de lier cette température $T_c$ aux deux puissances évoquées précédemment au moyen de l'équation suivante :

$$I_c\frac{\partial T_c}{\partial t} = P_{ch} - P_{rad} \quad (3)$$

où $I_c$ est le coefficient d'inertie du système de chauffage (circuit et radiateurs). Dans ce mode de réalisation, le modèle ne tient pas compte des pertes de distribution ou bien encore de la puissance de pompage. Cependant, dans un autre mode de réalisation, ces deux paramètres pourront également être intégrés au modèle.

La puissance de chauffage $P_{ch}$ est en général régulée afin d'imposer une consigne de température du fluide en entrée du circuit de chauffage $T_c^*$. Cette régulation peut être modélisée par l'équation suivante :

$$P_{ch} = P_{ch-nom}\frac{T_c^*-T_c}{\delta T} \quad (4) \quad \text{avec } \delta T \ll 1$$

où $P_{ch-nom}$ est la puissance nominale du système de chauffage et $\delta T$ un paramètre numérique correspondant à un écart de température, $\delta T$ étant par exemple égal à 0.1 °C. On entend par « puissance nominale » la puissance caractéristique, liée au dimensionnement du système de chauffage pour lui permettre de fournir la puissance de chauffage estimée d'un bâtiment dans les situations de froid extrême (en général on dimensionne pour une température extérieure de -11°C en France), Dans un autre mode de réalisation, ce modèle pourra être modifié en prenant en compte un bornage entre un minimum technique du système de chauffage et une valeur maximale qui pourrait être obtenue à partir de mesures définissant l'état énergétique du réseau de chauffage et disponible sur le réseau de chaleur. Dans un mode de réalisation, le minimum technique est égal au minimum de puissance à fournir pour éviter une dégradation des installations (par exemple éviter l'arrêt intempestif d'une chaudière) et la valeur maximale est égale au maximum de puissance pouvant être fourni par un réseau de chaleur, dépendant de la température courante du réseau au niveau de la sous-station.

Comme cela a été fait pour la puissance de chauffage $P_{ch}$, il est possible de prendre en compte la régulation de la puissance émise par les radiateurs $P_{rad}$. Cette régulation permet de lier la puissance de chauffage $P_{ch}$ et la puissance émise par les radiateurs $P_{rad}$ à travers l'équation suivante :

$$P_{rad} = P_{ch-nom}.f(T_c)\frac{g(T_{int}^* - T_{int})}{\delta T} \quad (5) \quad \text{avec } \delta T \ll 1$$

où g est une fonction de bornage dont la valeur varie entre 0 et $\delta T$ de sorte à garantir une valeur de la puissance émise par les radiateur $P_{rad}$ comprise entre 0 et $P_{ch-nom}$, et $f(T_c)$ est un terme de modulation linéaire permettant de limiter la puissance émise par les radiateurs $P_{rad}$ lorsque la température du circuit de chauffage est trop faible. Cette modulation prend en général la forme suivante :

$$f(T_c) = \frac{T_c - T_c^{min}}{T_c^{max} - T_c^{min}} \quad (6)$$

où $T_c^{min}$ est la valeur minimale pour la température de départ du circuit de chauffage et $T_c^{max}$ est la valeur maximale pour la température de départ du circuit de chauffage.

L'ensemble des considérations précédentes n'est qu'une illustration à travers un exemple particulier de l'étape de détermination d'un modèle initial de fonctionnement du bâtiment. Les équations peuvent varier en fonction du bâtiment et/ou des hypothèses considérés. Une telle modélisation relève cependant de la pratique quotidienne de l'homme du métier et n'est illustrée ici qu'afin de permettre une meilleure compréhension des différentes étapes du procédé selon un premier aspect de l'invention. Le modèle obtenu dans l'exemple détaillé précédent peut être synthétisé sous la forme de deux équations.

$$I_{bat}\frac{\partial T_{int}}{\partial t} = \frac{P_{ch-nom}}{\delta T}.f(T_c).g.(T_{int}^* - T_{int}) - UA(T_{int} - T_{ext}) \quad (7)$$

$$I_c\frac{\partial T_c}{\partial t} = \frac{P_{ch-nom}}{\delta T}\{(T_c^* - T_c) - f(T_c).g.(T_{int}^* - T_{int})\} \quad (8)$$

Ces deux équations permettent de reprendre les trois paramètres principaux du problème que sont l'inertie du bâtiment $I_{bat}$, l'inertie du circuit de chauffage $I_c$ et le coefficient de perte généralisé du bâtiment UA.

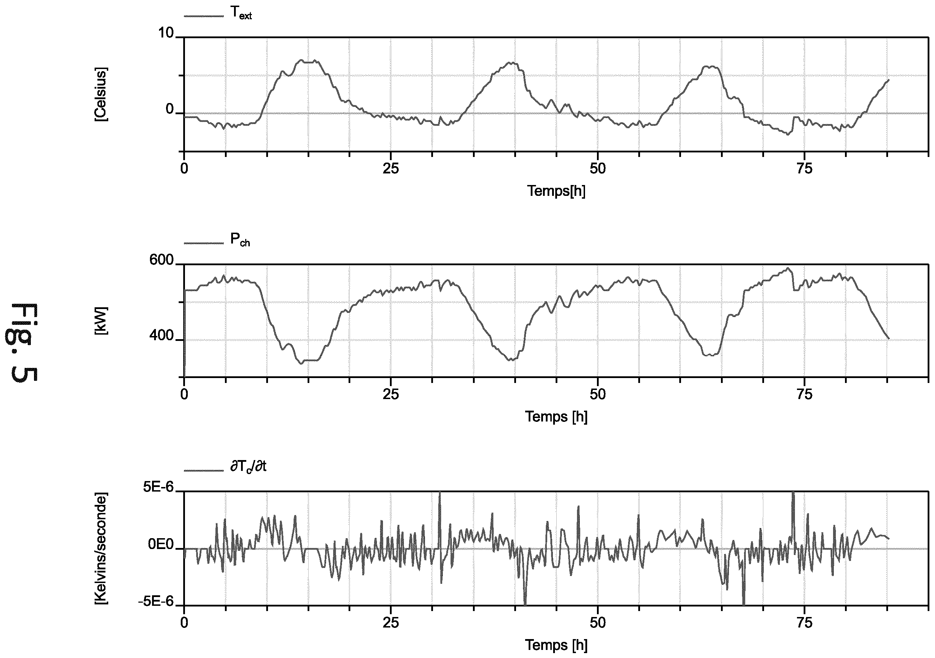

La figure 5 illustre l'évolution de la température extérieure $T_{ext}$, de la puissance de la chaufferie $P_{ch}$ ainsi que la variation de la température du fluide en sortie de l'échangeur $\frac{\partial T_c}{\partial t}$ durant une période de fonctionnement nominal. En fonctionnement nominal, la température du circuit de chauffage $T_c$ et la température interne du bâtiment $T_{int}$ ne varient que très faiblement ou, autrement dit, $\frac{\partial T_{int}}{\partial t} \ll 1$ et $\frac{\partial T_c}{\partial t} \ll 1$. Il en résulte qu'à partir des mesures dont dispose le système de chauffage, seuls certains paramètres du modèle sont déterminables. Les cycles jour/nuit apparaissent clairement sur la courbe représentant la température extérieure $T_{ext}$ en fonction du temps sous la forme d'oscillations. Il est également important de noter que la variation de la température du fluide en sortie de l'échangeur $\frac{\partial T_c}{\partial t}$ reste faible. Autrement dit, bien que la température extérieure $T_{ext}$ change, le système de régulation fait évoluer la puissance de chauffage $P_{ch}$ de sorte que la température du fluide en sortie de l'échangeur $T_c$ reste constante et la plus proche possible de la température de consigne $T_c^*$.

Afin de pouvoir déterminer l'ensemble des paramètres du modèle, le procédé selon un premier aspect de l'invention comprend également une étape E2 de perturbation de la puissance $P_{ch}$ d'alimentation du système de chauffage dudit bâtiment. La réponse du bâtiment à ladite perturbation est en outre mesurée lors d'une étape E3 de mesure de la réponse dudit bâtiment à ladite perturbation, ladite étape de mesure ne comprenant pas de mesure de la température

intérieure $T_{int}$ du bâtiment. En d'autres termes, les mesures effectuées lors de cette étape n'incluent pas de mesure de la température intérieure $T_{int}$ de bâtiment dont on cherche à déterminer la capacité de délestage K. A partir de ces mesures, les paramètres du modèle sont déterminés lors d'une étape E4 de détermination des paramètres du modèle initial de fonctionnement du bâtiment à partir de la mesure de la réponse dudit bâtiment, ladite détermination étant fonction du modèle initial de fonctionnement du bâtiment. Enfin, le procédé comprend une étape E5 de détermination de la capacité de délestage K du bâtiment à partir des paramètres du modèle initial, ladite détermination étant fonction du modèle initial de fonctionnement du bâtiment.

Dans un mode de réalisation non revendiqué, la perturbation est inhérente au fonctionnement normal du système de chauffage du bâtiment dont on cherche à déterminer la capacité de délestage. Dans un exemple de réalisation, cette perturbation est induite par le réduit de nuit, ce dernier faisant par exemple baisser systématiquement la température entre minuit et 5h du matin.

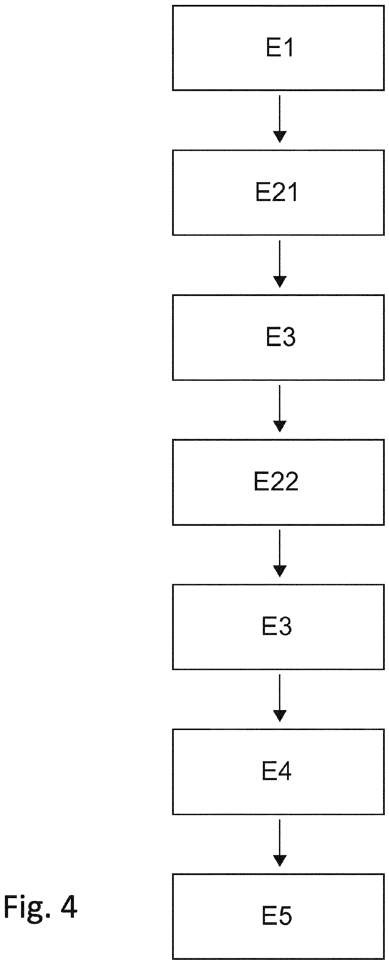

Dans un mode de réalisation alternatif ou complémentaire illustré à la figure 4, l'étape E2 de perturbation de la puissance $P_{ch}$ d'alimentation du système de chauffage dudit bâtiment comprend :

- une première sous-étape E21 de réduction d'une consigne de température $T_c^*$ durant une première période;

- une deuxième sous-étape E22 de réduction de la consigne de température $T_c^*$ durant une deuxième période.

De plus la réduction effectuée lors de la première sous-étape E21 de réduction est inférieure, par exemple deux fois inférieure, à la réduction effectuée lors de la deuxième sous-étape de réduction, l'étape E3 de mesure de la réponse du bâtiment à une perturbation de la puissance $P_{ch}$ d'alimentation étant répétée pour chacune de ces sous-étapes.

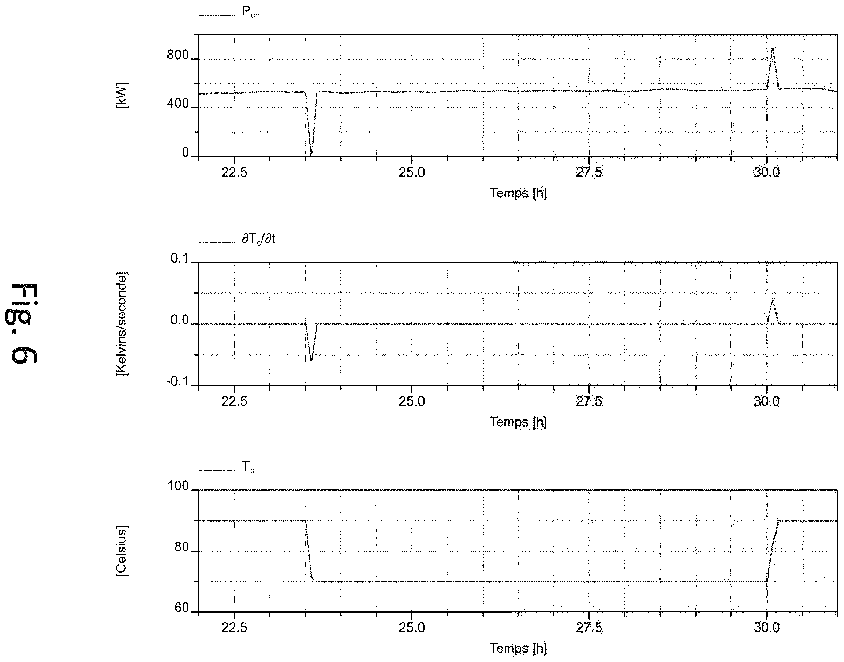

Dans un mode de réalisation, la première sous-étape E21 consiste en une légère réduction de la température de consigne de la température du circuit de chauffage $T_c^*$, et ceci pendant un premier intervalle de temps déterminé. Une telle perturbation va entrainer deux périodes de variation de la puissance de chauffage $P_{ch}$, la première période correspondant à l'ajustement de la température du circuit de chauffage $T_c$ pour rejoindre la nouvelle température de consigne du circuit de chauffage $T_c^*$, la deuxième période correspondant à l'ajustement de la température du circuit de chauffage $T_c$ pour rejoindre la consigne de fonctionnement normal à l'issue de la perturbation. Ces variations vont être mesurées lors d'une première itération de l'étape E3 de mesure de la réponse du bâtiment. Un exemple d'une telle perturbation est illustré à la figure 6 qui représente l'évolution de la puissance de chauffage $P_{ch}$, de la variation de la température en entrée du circuit de chauffage $\frac{\partial T_c}{\partial t}$ et de la température en entrée du circuit de chauffage $T_c$ en fonction du temps. Dans cet exemple, la consigne de température en entrée du circuit de chauffage $T_c^*$ est abaissée de 20°C passant de 90°C à 70°C et cette modification est maintenue pendant six heures.

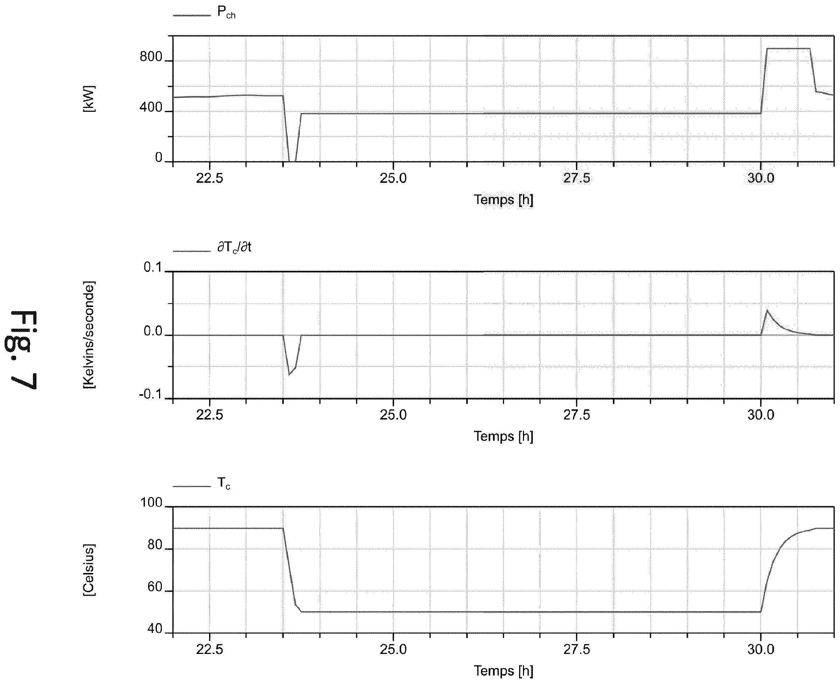

Dans un mode de réalisation, la deuxième sous-étape E22 consiste quant à elle en une forte réduction de la température de consigne de la température du circuit de chauffage $T_c^*$, et ceci pendant un second intervalle de temps déterminé. Une telle perturbation va entrainer deux périodes de variation de la puissance de chauffage $P_{ch}$, la première période correspondant à l'ajustement de la température du circuit de chauffage $T_c$ pour rejoindre la température de consigne du circuit de chauffage $T_c^*$ mais également à un plafonnement de la puissance émise par les radiateurs à niveau constant, la deuxième période correspondant à l'ajustement de la température du circuit de chauffage $T_c$ pour rejoindre la consigne de fonctionnement normal à l'issue de la perturbation. Un exemple d'une telle perturbation est illustré à la figure 7 qui représente l'évolution de la puissance de chauffage $P_{ch}$, de la variation de la température en entrée du circuit de chauffage $\frac{\partial T_c}{\partial t}$ et de la température en entrée du circuit de chauffage $T_c$ en fonction du temps.

Dans cet exemple, la consigne de température en entrée du circuit de chauffage $T_c^*$ est abaissée de 40°C passant de 90°C à 50°C et cette modification est maintenue pendant six heures.

Dans un mode de réalisation, l'étape E4 de détermination des paramètres du modèle initial s'effectue à partir des mesures réalisées lors des différentes itérations l'étape E3 de mesure de la réponse dudit bâtiment à ladite perturbation.

Dans un mode de réalisation, l'étape de détermination des paramètres du modèle initial prend tout d'abord en compte la réponse du bâtiment avant la perturbation telle qu'illustrée à la figure 4, c'est-à-dire lorsque le système de chauffage est en fonctionnement nominal. A partir de ces mesures, le coefficient de perte généralisé du bâtiment UA peut être déterminé. En effet, compte tenu de la faible variation de la température du circuit de chauffage $T_c$ et de la température intérieure du bâtiment $T_{int}$, la puissance fournie au système de chauffage peut s'écrire sous la forme suivante (en utilisant les équations (1), (2) et (3)) :

$$P_{ch} = -UA(T_{int} - T_{ext}) \quad (9)$$

Sachant en outre que la température intérieure $T_{int}$ est égale à la température de consigné $T_{int}^*$ que l'on peut supposer elle-même égale à 20 °C (le système de chauffage étant en mode nominal), il est possible de déterminer le coefficient de perte généralisé du bâtiment UA qui, dans cet exemple de réalisation, vaut 26000 W/K (Watt par Kelvin). Comme expliqué auparavant, la mesure de la température intérieure $T_{int}$ n'est pas nécessaire, seule la connaissance de la consigne de température intérieure $T_{int}^*$ étant requise.

Dans un mode de réalisation, la température extérieure $T_{ext}$ est extraite de prévisions météorologiques. Dans ce cas-là, le système de chauffage comporte des moyens pour interroger, par exemple via Internet, une base de données comprenant des données météorologiques relatives à la zone géographique correspondant au bâtiment. Dans un mode de réalisation alternatif ou complémentaire, la température extérieure est obtenue par un ou plusieurs capteurs de température à proximité du bâtiment. Dans ce cas-là, le système de chauffage comporte des moyens pour interroger, par exemple via une connexion sans-fil, ledit ou lesdits capteurs de température.

Dans un mode de réalisation, l'étape de détermination des paramètres du modèle initial prend également en compte la réponse du bâtiment à la perturbation induite lors de première sous-étape E21 de réduction d'une consigne de température $T_c^*$ durant une première période. Il convient par ailleurs de noter que lors de cette perturbation, la température interne $T_{int}$ reste égale à la température intérieure de consigne $T_{int}^*$ et que donc $\frac{\partial T_{int}}{\partial t} \cong 0$, une fois la température $T_c$ stabilisée, la puissance $P_{ch}$ continuant de varier en suivant les variations de température extérieure $T_{ext}$ et n'atteignant pas les limites du système de chauffage. Cette hypothèse permet de considérer, en combinant l'équation (1) et l'équation (2) que la puissance émise par les radiateurs $P_{rad}$ est donnée par $P_{rad} = UA. (T_{int}^* - T_{ext})$. A partir de cette équation, il est possible de reformuler l'équation (3) de la manière suivante.

$$I_c \frac{\partial T_c}{\partial t} = P_{ch} - UA. (T_{int}^* - T_{ext})$$

L'inertie du système de chauffage $I_c$ est ensuite déterminée, par exemple en intégrant l'équation précédente (obtenue à partir de l'équation (8) et en prenant en compte l'hypothèse précédemment décrite) durant les périodes pendant lesquelles la température $T_c$ varie. Dans l'exemple illustré en figure 6 et en intégrant l'équation précédente sur les périodes durant lesquelles la température $T_c$ varie, par exemple entre 30h et 31h, on obtient une énergie de 1.66e[8] Joules, et la valeur de l'inertie du système de chauffage $I_c$ peut donc être estimée comme étant égale à 8.36e[6] J/K (Joules par Kelvin). Encore une fois, la mesure de la température intérieur $T_{int}$ n'est pas nécessaire, seule la connaissance de la consigne de température intérieure $T_{int}^*$ étant requise.

Dans un mode de réalisation, l'étape de détermination des paramètres du modèle initial prend également en compte la réponse du bâtiment à la perturbation induite lors de deuxième sous-étape E22 de réduction d'une consigne de température $T_c^*$ durant une deuxième période. Durant cette perturbation, la température intérieure $T_{int}$ chute jusqu'à atteindre une température seuil à laquelle la puissance maximale émise par les radiateurs lui permet de se maintenir. Plus particulièrement, cette température seuil peut être dérivée de l'équation (7) en tenant compte du fait que, dans ce mode de réalisation, $\frac{g(T_{int}^* - T_{int})}{\delta T} = 1$ et que $\frac{\partial T_{int}}{\partial t} \cong 0$ de sorte à obtenir la relation suivante.

$$T_{int}^{seuil} = T_{ext} - \frac{f(T_c)P_{ch-nom}}{UA}$$

On considère donc que la température de seuil $T_{int}^{seuil}$ est atteinte durant la perturbation. Autrement dit, la durée et l'amplitude de la perturbation doivent être suffisantes pour que ladite température seuil $T_{int}^{seuil}$ soit atteinte. Cette condition étant remplie, on détermine l'inertie du bâtiment $I_{bat}$ en intégrant la variation d'énergie, autrement dit en intégrant la puissance de chauffage $P_{ch}$ durant la deuxième période de variation de cette même puissance et en considérant que l'énergie ainsi obtenue est l'énergie nécessaire pour rétablir la température intérieure $T_{int}$ du bâtiment de sorte que $T_{int} = T_{int}^*$. Cette énergie est par définition égale à $I_{bat}(T_{int}^* - T_{int}^{seuil})$. Pour cela, on détermine tout d'abord la valeur de la température intérieure, c'est-à-dire la valeur de la température intérieure seuil $T_{int}^{seuil}$. Cette variable dépendant de la température extérieure $T_{ext}$, il est préférable de déterminer la valeur de température seuil $T_{int}^{seuil}$ lorsque la température extérieure $T_{ext}$ varie peu, par exemple au lever du jour. Dans l'exemple de réalisation illustré à la figure 7, on considère que la température seuil $T_{int}^{seuil}$ est atteinte avant 30h et la puissance $P_{ch}$ est intégrée durant la période de variation comprise entre 30h et 31h. L'écart d'énergie obtenu par intégration est égal à $7,46e^8$ Joules ce qui correspond à une inertie du bâtiment $I_{bat}$ égale à $1,254e^8$ J/K (Joules par Kelvin). Comme précédemment, la mesure de la température intérieure $T_{int}$ n'est pas nécessaire.

A l'issue de cette étape E4 de détermination des paramètres du modèle, l'ensemble des paramètres du modèle ont été obtenus, et ce, à partir de la mesure de la réponse du bâtiment à une perturbation induite par le système de chauffage n'incluant pas de mesure de la température intérieure $T_{int}$.

Le procédé comprend également une étape E5 de détermination de la capacité de délestage du bâtiment à partir des paramètres du modèle précédemment déterminés ainsi que du modèle initial. Dans un exemple de réalisation, cette capacité de délestage peut être exprimée à l'aide de l'expression suivante.

$$K = I_{bat}(T_{int} - T_{int}^{lim})$$

où $T_{int}^{lim}$ est la température basse limite que l'on souhaite avoir lors du délestage. Dans l'exemple de réalisation précédent et en fixant $T_{int}^{lim}$ égal à 18°C, on obtient une capacité de délestage de $1.881e8$ Joules, soit 52.25 kWh. Dans un mode de réalisation, la température interne $T_{int}$ considérée est une température de consigne habituelle, typiquement 20°C. Dans un mode de réalisation alternatif non revendiqué, la température interne $T_{int}$ est calculée à l'aide du modèle dont les paramètres ont été déterminés lors de l'étape cette étape E4 de détermination des paramètres du modèle, ce qui permet notamment de tenir compte des actions de délestage déjà effectuées.

Ainsi, à l'issue du procédé selon un premier aspect de l'invention et en mesurant la réponse d'un bâtiment à une perturbation, la capacité de délestage du bâtiment est déterminée.

Dans un mode de réalisation, le modèle prend en compte la puissance consommée pour la production de l'eau chaude sanitaire. Cette puissance consommée est introduite dans le modèle évoqué précédemment au moyen de la puissance des apports internes $P_{ai}$, cette dernière pouvant alors être formulée de la manière suivante.

$$P_{ai} = \beta . \overline{P_{SST-ECS}}$$

où $\overline{P_{SST-ECS}}$ est le profil de puissance moyen nécessaire à la production d'eau chaude et $\beta$ est un coefficient de proportionnalité dépendant du système de production d'eau chaude utilisé.

Dans un mode de réalisation, le modèle prend en compte la présence d'au moins une dalle chauffante. Cet aspect est intégré au modèle en modifiant l'expression du coefficient de modulation linéaire dans la puissance émise par les radiateurs comme suit.

9

$$f(T_c) = \frac{T_c(t - \tau_{dalle}) - T_c^{min}}{T_c^{max} - T_c^{min}}$$

où $\tau_{dalle}$ est un temps de retard associé à la dalle. Il est ainsi possible de prendre en compte la présence d'une dalle chauffante dans la détermination de la capacité de délestage K d'un bâtiment.

Dans un mode de réalisation, le procédé selon un premier aspect de l'invention comprend une étape de mise à jour du modèle physique, l'étape E2 de perturbation de la puissance $P_{ch}$ d'alimentation du système de chauffage, l'étape E3 de mesure de la réponse dudit bâtiment à une perturbation, l'étape E4 de détermination des paramètres du modèle initial et l'étape E5 de détermination de la capacité de délestage K du bâtiment étant à nouveau mise en œuvre lors de cette mise à jour. Ainsi, une modification du modèle entraine un nouveau calcul de la capacité de délestage du bâtiment.

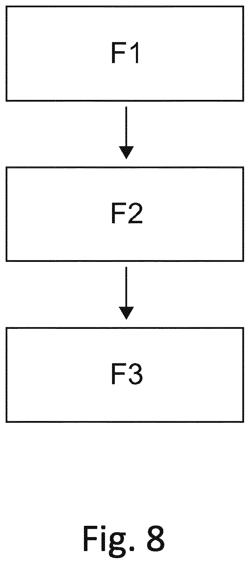

Une fois que la capacité de délestage K d'un bâtiment a été déterminée, il devient possible de procéder au délestage dudit bâtiment de manière optimisée. Pour cela, un deuxième aspect de l'invention illustré en figure 8 concerne un procédé de délestage d'un bâtiment ledit bâtiment comprenant un système de chauffage alimenté par une puissance $P_{eh}$.

Le procédé comprend une étape F1 de mise en œuvre d'un procédé de détermination de la capacité de délestage K dudit bâtiment selon un premier aspect de l'invention. Comme nous venons de le détailler, à l'issue de cette étape, la capacité de délestage K du bâtiment est connue.

Le procédé comprend également une étape F2 de détermination des consignes de délestage optimales à partir de la capacité de délestage déterminée. Par exemple, les consignes peuvent être déterminées afin de minimiser les émissions de gaz à effet de serre. Sachant que la production d'énergie associée à un niveau élevé d'émissions de gaz à effet de serre correspond à la production ayant un coût financier plus élevé, l'optimisation est alors faite en fonction du coût associé à l'énergie. Ainsi, les consignes de délestage sont calculées de sorte à maximiser l'énergie délestée lors des périodes durant lesquelles le prix associé à l'énergie est maximal. Par exemple, cette optimisation peut consister à maximiser la fonction suivante.

$$\Delta = \int_0^{T_d} P(t)C(t)dt$$

où P(t) est la puissance délestée à un temps t, C(t) est le coût de l'énergie à un temps t et $T_d$ est la durée du délestage. Cette optimisation doit être effectuée tout en s'assurant que la puissance délestée sur la période de délestage n'excède pas les capacités de délestage, autrement dit que la relation suivante soit respectée.

$$K \geq \int_0^{T_d} P(t)dt$$

Le procédé comprend enfin une étape F3 de mise en œuvre desdites consignes de délestage par le système de chauffage. Ainsi, le délestage du bâtiment est effectué de manière optimale, par exemple en minimisant l'impact carbone de ce dernier. L'optimisation pourra bien entendu être effectuée en fonctions d'autres critères. Par exemple, dans un mode de réalisation, chaque occupant du bâtiment peut indiquer la température intérieure minimale souhaitée lors d'un délestage. Cette indication pourra être fixe ou varier en fonction de l'heure de la journée et/ou du jour de la semaine. Ainsi, le délestage peut être effectué tout en respectant le confort de chaque occupant.

Dans un mode de réalisation, le procédé comprend à l'issue de l'étape F2 de détermination des consignes de délestage optimales, une étape de vérification des consignes de délestage déterminées lors de l'étape F2 de détermination des consignes de délestage.

Dans un mode de réalisation, cette étape de vérification des consignes de délestage comprend une première sous-étape de simulation de la réponse du bâtiment à partir desdites consignes et du modèle du bâtiment. Durant cette première sous-étape, une simulation est effectuée sur la base du modèle déterminé auparavant lors de l'étape E1 de détermination du modèle initial de fonctionnement du bâtiment.

L'étape de vérification des consignes de délestage comprend également une deuxième sous-étape de vérification de la conformité de la réponse obtenue. Cette deuxième sous-étape permet notamment de vérifier que les températures estimées à l'intérieur du bâtiment à l'aide de la simulation sont conformes aux limites de température

$T_{int}^{lim}$ imposées. Elle permet en outre de s'assurer que les hypothèses retenues au moment du calcul sont toujours valides.

Enfin, l'étape de vérification des consignes de délestage comprend, lorsque la réponse n'est pas conforme, une troisième sous-étape de correction desdites consignes. Cette correction peut par exemple être effectuée de sorte à limiter la puissance fournie au système de chauffage du bâtiment et entraine la définition d'une nouvelle température de consigne de température $T_c^*$ de sorte que la puissance fournie soit conforme aux consignes corrigées.

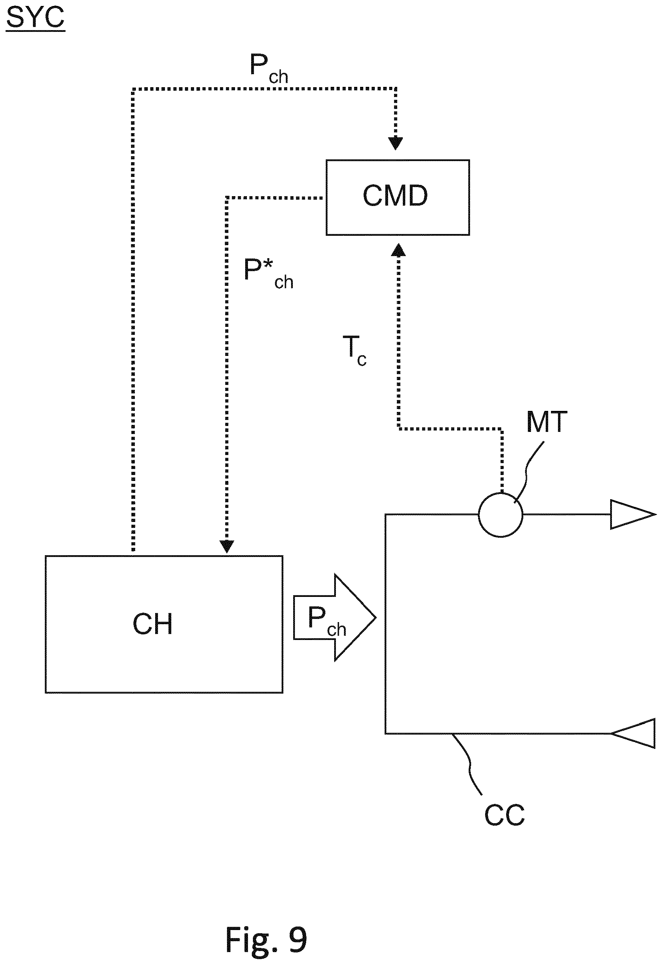

Afin de mettre en œuvre un procédé selon un premier aspect ou un deuxième aspect de l'invention, un troisième aspect de l'invention illustré à la figure 9 concerne un système de chauffage SYC comportant un circuit de chauffage CC, ledit système SYC étant alimenté par une puissance P$_{ch}$. Le système comprend en outre des moyens pour mettre en œuvre un procédé de détermination de la capacité de délestage K d'un bâtiment 1 selon un premier aspect de l'invention ou un procédé de délestage d'un bâtiment 1 selon un deuxième aspect de l'invention.

Dans un mode de réalisation, le système de chauffage SYC comprend un capteur de température MT mesurant la température T$_c$ du fluide à l'entrée du circuit de chauffage CC. Le circuit de chauffage CC reçoit en outre de la part d'un dispositif de chauffage CH (par exemple une chaudière) une puissance P$_{ch}$ qu'il est possible de réguler. Afin de réguler le chauffage au sein du bâtiment, le système de chauffage SYC comprend également un moyen de commande CMD comportant des moyens de calcul, des moyens de mémorisation et des moyens de communication de sorte à pouvoir communiquer avec le dispositif de chauffage CH et le capteur de température MT. Le moyen de commande CMD est en outre configuré pour mesurer la puissance P$_{ch}$ reçue par le circuit de chauffage ainsi que la température T$_c$ en entrée dudit circuit de chauffage CC. Le moyen de commande est également configuré pour déterminer un modèle initial de fonctionnement du bâtiment caractérisant l'état d'équilibre dudit bâtiment. Cette détermination peut par exemple être obtenue par un moyen de saisie permettant à un opérateur de saisir, dans la mémoire du moyen de commande CMD, les paramètres du modèle. De manière alternative ou complémentaire, le moyen de commande CMD est configuré pour se connecter à un réseau, par exemple Internet, et recevoir les paramètres du modèle depuis un ordinateur distant.

De plus, le moyen de commande CMD est également configuré pour perturber la puissance P$_{ch}$ d'alimentation du système de chauffage dudit bâtiment et pour, lorsque le bâtiment subit une perturbation dans la puissance P$_{ch}$ d'alimentation du système de chauffage, mesurer la réponse dudit bâtiment. Cette mesure peut être faite en mesurant la puissance de chauffage P$_{ch}$ fournie au circuit de chauffage et de la température T$_c$ d'entrée du circuit de chauffage durant ladite perturbation.

Le moyen de commande CMD est également configuré pour déterminer les paramètres du modèle initial de fonctionnement du bâtiment à partir de la mesure de la réponse dudit bâtiment, ladite détermination étant fonction du modèle initial de fonctionnement du bâtiment et pour déterminer la capacité de délestage K du bâtiment à partir de la mesure de la réponse dudit bâtiment, ladite détermination étant fonction du modèle initial de fonctionnement du bâtiment.

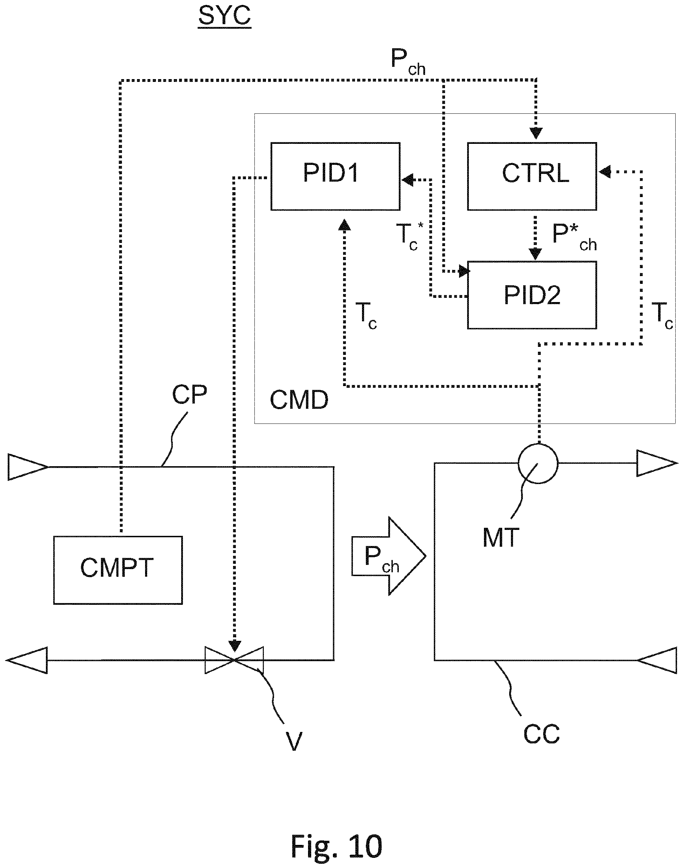

Dans un mode de réalisation illustré à la figure 10, le système de chauffage SYC est connecté à un réseau de chaleur par l'intermédiaire d'un circuit primaire CP et reçoit de la part dudit réseau de chauffage une puissance P$_{ch}$ qu'il est possible de moduler à l'aide d'une vanne V. Afin de mesurer la puissance P$_{ch}$ fournie par le réseau de chaleur, le système de chauffage SYC comprend également un compteur d'énergie CMPT.

De plus, le moyen de commande CMD comprend un contrôleur CTRL, un premier régulateur PID1 et un deuxième régulateur PID2. Le contrôleur CTRL comporte des moyens de calcul, des moyens de mémorisation et des moyens de communication de sorte à pouvoir communiquer avec le compteur d'énergie CMPT, avec le capteur de température MT et la vanne V du circuit primaire ainsi qu'avec le premier régulateur PID1 et le deuxième régulateur PID2. Plus particulièrement, le compteur d'énergie CMPT fournit au contrôleur CTRL et au deuxième régulateur PID2 la puissance P$_{ch}$ fournie par le réseau de chaleur RC au circuit de chauffage CC. Le contrôleur CTRL déduit de cette puissance fournie P$_{ch}$ une puissance de consigne $P_{ch}^*$ et communique cette dernière au deuxième régulateur PID2 qui détermine, à partir de cette consigne de puissance $P_{ch}^*$, une consigne en température $T_c^*$ du fluide en sortie de l'échangeur du circuit de chauffage. Cette consigne est envoyée par le deuxième régulateur PID2 au premier régulateur PID1 qui, en fonction de cette consigne, pilote la vanne V, contrôlant ainsi la puissance de chauffage P$_{ch}$ fournie par le réseau de chauffage au circuit de chauffage CC.

De plus, le contrôleur CTRL en collaboration avec le premier régulateur PID1 et le deuxième régulateur PID2 est configuré pour mettre en œuvre un procédé de détermination de la capacité de délestage selon un premier aspect de l'invention. Le système de chauffage SYC ainsi obtenu comporte donc les moyens pour mettre en œuvre un procédé de détermination de capacité de délestage d'un bâtiment selon un premier aspect de l'invention.

Dans un mode de réalisation, afin de mettre en œuvre l'étape E2 de perturbation du procédé selon un premier aspect de l'invention, le contrôleur CTRL, en collaboration avec le premier régulateur PID1 et le deuxième régulateur PID2, est configuré pour réduire une première fois la consigne de température $\mathrm{T}_c^*$ pendant une première période de temps et réduire une deuxième fois la consigne de température $\mathrm{T}_c^*$ pendant une deuxième période tout en s'assurant que la réduction effectuée lors de la première période est inférieure à la réduction effectuée lors de la deuxième période. De plus, le contrôleur CTRL, en collaboration avec le premier régulateur PID1 et le deuxième régulateur PID2, est configuré pour mesurer la réponse du bâtiment à une perturbation de la puissance $P_{ch}$ durant chacune de ces périodes. Comme expliqué précédemment, cette mesure peut notamment se faire à l'aide du compteur de puissance CMTP et du capteur de température MT'

Dans un mode de réalisation, le contrôleur CTRL du système de chauffage est également configuré pour déterminer des consignes de délestage optimales à partir de la capacité de délestage déterminée auparavant et mettre en œuvre desdites consignes de délestage. La détermination des consignes de délestage optimale peut notamment être effectuée par le moyen de calcul du contrôleur CTRL.

Il ne s'agit bien entendu que d'un exemple de réalisation d'un système de chauffage comportant les moyens pour mettre en œuvre un procédé de détermination de la capacité de délestage d'un bâtiment selon un premier aspect de l'invention ou un procédé de délestage selon un deuxième aspect de l'invention. On peut en effet envisager d'autres configurations pour le système de chauffage.

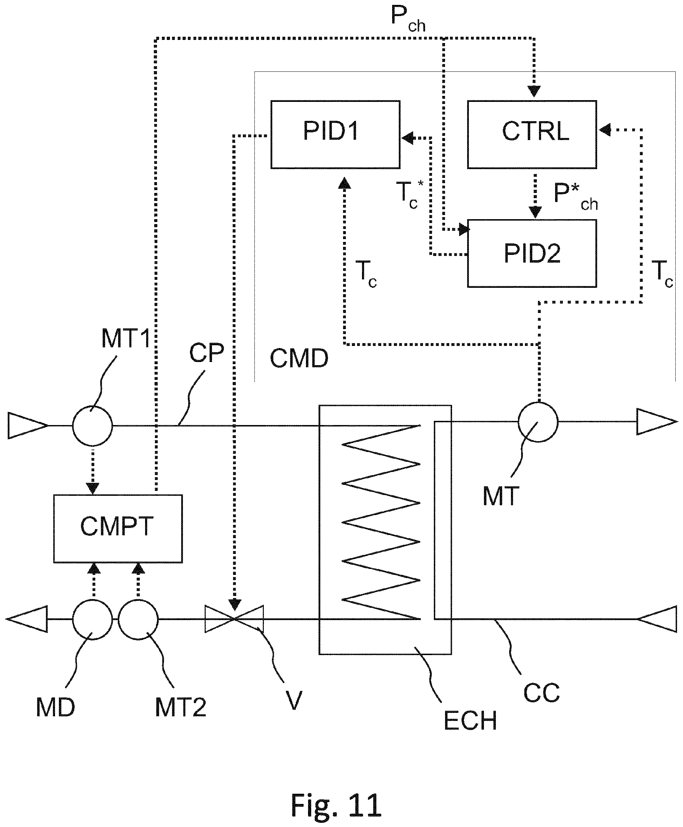

Dans un mode de réalisation illustré à la figure 11, le système de chauffage comprend également un échangeur ECH permettant d'échanger de la chaleur entre le circuit primaire CP et le circuit de chauffage CC. Le système de chauffage comprend en outre un moyen de mesure du débit MD, mesurant le débit circulant dans le circuit primaire CP. De plus, le système comprend également un premier moyen de mesure de la température d'entrée MT1 du circuit primaire CP et un deuxième moyen de mesure de la température de sortie MT2 du circuit primaire CP. En outre, le premier moyen de mesure de la température d'entrée MT1, le deuxième moyen de mesure de la température de sortie MT2 et moyen de mesure du débit MD sont connectés au compteur CMPT. Ainsi, le compteur CMPT peut déterminer la puissance $P_{ch}$ fournie par le réseau de chaleur au circuit de chauffage CC.

## Revendications

1. Procédé de détermination de la capacité de délestage K d'un bâtiment, ledit bâtiment comprenant un système de chauffage alimenté par une puissance $P_{ch}$ et comprenant un circuit de chauffage, ledit système de chauffage étant configuré pour moduler l'énergie transmise à l'intérieur du bâtiment en fonction d'une consigne de température intérieure $T_{int}^*$, la capacité de délestage $K$ étant la réduction de la puissance d'alimentation $P_{ch}$ sur une période donnée qu'il est possible d'appliquer à un bâtiment sans que la température intérieure $T_{int}$ du bâtiment concerné ne chute en deçà d'une température minimale $\mathrm{T}_{int}^{lim}$ fixée, le procédé comprenant une étape (E1) de détermination d'un modèle initial de fonctionnement du bâtiment caractérisant l'état d'équilibre dudit bâtiment, prenant en compte l'inertie $I_{bat}$ dudit bâtiment ; ledit procédé étant **caractérisé en ce qu'**il comprend :

   - une étape (E2) de perturbation de la puissance $P_{ch}$ d'alimentation du système de chauffage dudit bâtiment, la perturbation étant induite par une modification de la consigne de température $T_c^*$ du circuit de chauffage comportant :

     ■ une première sous-étape (E21) de réduction de la consigne de température $\mathrm{T}_c^*$ durant une première période ;

     ■ une deuxième sous-étape (E22) de réduction de la consigne de température $\mathrm{T}_c^*$ durant une deuxième période lors de laquelle la température intérieure $T_{int}$ atteint une température seuil $T_{int}^{seuil}$ donnée par :

$$\mathrm{T}_{int}^{seuil} = \mathrm{T}_{ext} - \frac{f(\mathrm{T}_c)P_{ch-nom}}{UA}$$

où $T_{ext}$ est la température extérieure, $P_{ch-nom}$ est la puissance nominale du système de chauffage, $f(T_c)$

est donné par la relation suivante :

$$f(T_c) = \frac{T_c - T_c^{min}}{T_c^{max} - T_c^{min}} \quad (6)$$

où $T_c$ est la température du circuit de chauffage, $T_c^{min}$ est la valeur minimale pour la température de départ du circuit de chauffage et $T_c^{max}$ est la valeur maximale pour la température de départ du circuit de chauffage et UA est le coefficient de perte généralisée du bâtiment déterminé à l'aide de la relation suivante :

$$P_{ch} = -UA(T_{int} - T_{ext})$$

en considérant que la température intérieure $T_{int}$ égale à la température interne de consigne $T_{int}^*$ lors du fonctionnement nominal du système de chauffage durant lequel la puissance de chauffage $P_{ch}$ évolue de sorte que la température $T_c$ du circuit de chauffage est constante et sensiblement égale à la température de consigne $T_c^*$ dudit système de chauffage pendant que la température extérieure $T_{ext}$ change ;
la réduction effectuée lors de la première sous-étape (E21) de réduction étant inférieure à la réduction effectuée lors de la deuxième sous-étape (E22) de réduction ;

- pour chacune des sous-étapes (E21 ,E22) de réduction de l'étape (E2) de perturbation, une étape (E3) de mesure de la réponse dudit bâtiment à ladite perturbation comprenant la mesure de la puissance $P_{ch}$ d'alimentation du système de chauffage durant ladite perturbation ;
- une étape (E4) de détermination des paramètres du modèle initial de fonctionnement du bâtiment à partir de la mesure de la réponse dudit bâtiment, ladite détermination étant fonction du modèle initial de fonctionnement du bâtiment et comportant la détermination de l'inertie thermique du bâtiment $I_{bat}$ par intégration de la puissance de chauffage $P_{ch}$ lors de la deuxième sous-étape (E22) de réduction en considérant que l'énergie ainsi calculée est égale à $I_{bat}\left(T_{int}^* - T_{int}^{seuil}\right)$ ;
- une étape (E5) de détermination de la capacité de délestage K du bâtiment à l'aide de la relation $K = I_{bat}(T_{int} - T_{int}^{lim})$ en supposant la température intérieure $T_{int}$ égale à la température de consigne $T_{int}^*$ prédéterminée.

2. Procédé selon la revendication précédente **caractérisé en ce que** le modèle déterminé lors de l'étape de détermination d'un modèle initial de fonctionnement du bâtiment prend en compte la puissance consommée pour la production de l'eau chaude sanitaire.

3. Procédé selon l'une des revendications précédentes **caractérisé en ce qu'**il comprend une étape de mise à jour du modèle physique, l'étape (E2) de perturbation de la puissance $P_{ch}$ d'alimentation du système de chauffage, l'étape (E3) de mesure de la réponse dudit bâtiment à ladite perturbation, l'étape (E4) de détermination des paramètres du modèle initial et l'étape (E5) de détermination de la capacité de délestage K du bâtiment étant à nouveau mises en œuvre lors de cette mise à jour.

4. Procédé selon l'une des revendications précédentes **caractérisé en ce que** le coefficient de perte généralisée du bâtiment déterminer en supposant en considérant que la température intérieure $T_{int}$ égale à la température de consigne $T_{int}^*$ lors du fonctionnement nominal du système de chauffage durant lequel la température $T_c$ du circuit de chauffage est constante et sensiblement égale à la température de consigne $T_c^*$ dudit système de chauffage.

**5.** Procédé de délestage d'un bâtiment ledit bâtiment comprenant un système de chauffage alimenté par une puissance $P_{ch}$, ledit procédé étant **caractérisé en ce qu'**il comprend :

- une étape (F1) de mise en œuvre d'un procédé de détermination de la capacité de délestage K dudit bâtiment selon l'une des revendications précédentes ;
- une étape (F2) de détermination des consignes de délestage optimales à partir de la capacité de délestage précédemment déterminée ;
- une étape (F3) de mise en œuvre desdites consignes de délestage par le système de chauffage.

**6.** Procédé selon la revendication précédente **caractérisé en ce que** le procédé comprend, à l'issue de la deuxième étape de détermination des consignes de délestage optimales, une étape de vérification des consignes de délestage déterminées lors de l'étape (F2) de détermination des consignes de délestage.

**7.** Procédé selon la revendication précédente **caractérisé en ce que** l'étape de vérification des consignes de délestage comprend :

- une première sous-étape de simulation de la réponse du bâtiment à partir desdites consignes et du modèle du bâtiment ;
- une deuxième sous-étape de vérification de la conformité de la réponse du bâtiment obtenue ;
- lorsque la réponse n'est pas conforme, une troisième sous-étape de correction desdites consignes.

**8.** Système de chauffage (SYC) alimenté par une puissance $P_{ch}$ **caractérisé en ce qu'**il comprend des moyens configurés pour mettre en œuvre un procédé de détermination de la capacité de délestage K d'un bâtiment selon l'une des revendications 1 à 4 ou un procédé de délestage d'un bâtiment selon l'une des revendication 5 à 7.

**9.** Programme d'ordinateur comprenant des instructions qui conduisent le système selon la revendication précédente à exécuter les étapes du procédé selon l'une des revendications 1 à 7.

**10.** Support lisible par ordinateur, sur lequel est enregistré le programme d'ordinateur selon la revendication précédente.

**Patentansprüche**

**1.** Bestimmungsverfahren der Entlastungskapazität K eines Gebäudes, wobei das genannte Gebäude ein Heizsystem umfasst, das von einer Leistung $P_{ch}$ versorgt wird, und umfassend einen Heizkreislauf, wobei das genannte Heizsystem zum Modulieren der Energie ausgestaltet ist, die im Innern des Gebäudes in Abhängigkeit von einem Sollwert der Innentemperatur $T^*_{int}$ übertragen wird, wobei die Entlastungskapazität K die Reduzierung der Versorgungsleistung $P_{ch}$ über einen bestimmten Zeitraum ist, die auf ein Gebäude angewendet werden kann, ohne dass die Innentemperatur $T_{int}$ des betroffenen Gebäudes unter eine festgesetzte Mindesttemperatur $T^{lim}_{int}$ fällt, wobei das Verfahren einen Bestimmungsschritt (E1) eines ursprünglichen Betriebsmodells des Gebäudes umfasst, das den ausgeglichenen Zustand des Gebäudes kennzeichnet, der die Trägheit $I_{bat}$ des genannten Gebäudes berücksichtigt; wobei das genannte Verfahren **dadurch gekennzeichnet ist, dass** es umfasst:

- einen Störungsschritt (E2) der Versorgungsleistung ($P_{ch}$) des Heizsystems des genannten Gebäudes, wobei die Störung durch eine Änderung des Temperatursollwerts $T^*_c$ des Heizkreislaufs hervorgerufen wird, umfassend:

  ■ einen ersten Reduzierungs-Teilschritt (E21) des Temperatursollwertes $T^*_c$ während eines ersten Zeitraums;
  ■ einen zweiten Reduzierungs-Teilschritt (E33) des Temperatursollwertes $T^*_c$ während eines zweiten Zeitraums, bei dem die Innentemperatur $T_{int}$ eine Grenzwert-Temperatur $T^{seuil}_{int}$ erreicht, die angegeben wird durch:

$$T_{int}^{seuil} = T_{ext} - \frac{f(T_c)P_{ch-nom}}{UA}$$

wobei $T_{ext}$ die Außentemperatur ist, $P_{ch-nom}$ die Nennleistung des Heizsystems ist, $f(T_c)$ durch die nachstehende Beziehung angegeben wird:

$$f(T_c) = \frac{T_c - T_c^{min}}{T_c^{max} - T_c^{min}} \quad (6)$$

wobei $T_c$ die Temperatur des Heizkreislaufs ist, $T_c^{min}$ der Mindestwert für die Ausgangstemperatur des Heizkreislaufs ist und $T_c^{max}$ der Höchstwert für die Ausgangstemperatur des Heizkreislaufe ist und UA der Koeffizient des generalisierten Verlustes des Gebäudes ist, der anhand der nachstehenden Beziehung bestimmt wird:

$$P_{ch} = -UA(T_{int} - T_{ext})$$

unter der Berücksichtigung, dass die Innentemperatur $T_{int}$ während des Nominalbetriebs des Heizsystems, bei dem die Heizleistung $P_{ch}$ sich derart entwickelt, dass die Temperatur $T_c$ des Heizkreislaufs konstant ist und gleich der Solltemperatur $T_c^*$ des genannten Heizsystems ist, während sich die Außentemperatur $T_{ext}$ ändert, gleich dem Sollwert der Innentemperatur $T_{int}^*$ ist;

wobei die beim ersten Reduzierungs-Teilschritt (E21) durchgeführte Reduzierung geringer ist als die beim zweiten Reduzierungs-Teilschritt (E22) durchgeführte Reduzierung;

- für jeden der Reduzierungs-Teilschritte (E21, E22) des Störungsschritts (E2) einen Messschritt (E3) der Antwort des genannten Gebäudes mit der genannten Störung, umfassend die Messung der Versorgungsleistung $P_{ch}$ des Heizsystems während der genannten Störung;
- einen Bestimmungsschritt (E4) der Parameter des ursprünglichen Betriebsmodells des Gebäudes ausgehend von der Messung der Antwort des genannten Gebäudes, wobei die genannte Bestimmung vom ursprünglichen Betriebsmodell des Gebäudes abhängt und die Bestimmung der thermischen Trägheit des Gebäudes $I_{bat}$ per Aufnahme der Heizleistung $P_{ch}$ beim zweiten Reduzierungs-Teilschritt (E22) unter der Berücksichtigung umfasst, dass die auf diese Weise berechnete Energie gleich $I_{bat}(T_{int}^* - T_{int}^{seuil})$ ist;
- einen Bestimmungsschritt (E5) der Entlastungskapazität K des Gebäudes mithilfe der Beziehung $K = I_{bat}(T_{int} - T_{int}^{lim})$ unter der Annahme, dass die Innentemperatur Tint gleich der vorbestimmten Solltemperatur T*int ist.

2. Verfahren gemäß dem voranstehenden Anspruch, **dadurch gekennzeichnet, dass** das beim Bestimmungsschritt eines ursprünglichen Betriebsmodells des Gebäudes bestimmte Modell die Leistung berücksichtigt, die für die Produktion von Warmwasser verbraucht wird.

3. Verfahren gemäß einem der voranstehenden Ansprüche, **dadurch gekennzeichnet, dass** es einen Aktualisierungsschritt des physischen Modells umfasst, wobei der Störungsschritt (E2) der Versorgungsleistung $P_{ch}$ des Heizsystems, der Messschritt (E3) der Antwort des genannten Gebäudes auf die genannte Störung, der Bestimmungsschritt (E4) der Parameter des ursprünglichen Modells und der Bestimmungsschritt (E5) der Entlastungskapazität K des Gebäudes bei dieser Aktualisierung erneut umgesetzt werden.

4. Verfahren gemäß einem der voranstehenden Ansprüche, **dadurch gekennzeichnet, dass** der Koeffizient des generalisierten Verlustes des Gebäudes unter der Annahme, dass die Innentemperatur $T_{int}$ beim Nominalbetrieb

des Heizsystems, bei dem die Temperatur $T_c$ des Heizkreislaufs konstant und deutlich gleich der Sollwert-Temperatur $T^*_c$ des genannten Heizsystems ist, gleich der Sollwerttemperatur $T^*_{int}$ ist.

5. Entlastungsverfahren eines Gebäudes, wobei das genannte Gebäude ein Heizsystem umfasst, das von einer Leistung $P_{ch}$ versorgt wird, wobei das genannte Verfahren **dadurch gekennzeichnet ist, dass** es umfasst:

   - einen Umsetzungsschritt (F1) eines Bestimmungsverfahrens der Entlastungskapazität K des genannten Gebäudes gemäß einem der voranstehenden Ansprüche;
   - einen Bestimmungsschritt (F2) der optimalen Entlastungs-Sollwerte ausgehend von der zuvor bestimmten Entlastungskapazität;
   - einen Umsetzungsschritt (F3) der genannten Entlastungs-Sollwerte durch das Heizsystem.

6. Verfahren gemäß dem voranstehenden Anspruch, **dadurch gekennzeichnet, dass** das Verfahren nach Abschluss des zweiten Bestimmungsschrittes der optimalen Entlastungs-Sollwerte einen Überprüfungsschritt der Entlastungs-Sollwerte umfasst, die beim Bestimmungsschritt (F2) der Entlastungs-Sollwerte bestimmt werden.

7. Verfahren gemäß dem voranstehenden Anspruch, **dadurch gekennzeichnet, dass** der Überprüfungsschritt der Entlastungs-Sollwerte umfasst:

   - einen ersten Simulations-Teilschritt der Antwort des Gebäudes ausgehend von den genannten Sollwerten des Modells des Gebäudes;
   - einen zweiten Überprüfungs-Teilschritt der Konformität der erhaltenen Antwort des Gebäudes;
   - wenn die Antwort nicht konform ist, einen dritten Korrektur-Teilschritt der genannten Sollwerte.

8. Durch eine Leistung $P_{ch}$ versorgtes Heizsystem (SYC), **dadurch gekennzeichnet, dass** es Mittel umfasst, die zum Umsetzen eines Bestimmungsprozesses der Entlastungskapazität K eines Gebäudes gemäß einem der Ansprüche 1 bis 4 oder ein Entlastungsverfahren eines Gebäudes gemäß einem der Ansprüche 5 bis 7 umfasst.

9. Computerprogramm, umfassend Anweisungen, die das System gemäß dem voranstehenden Anspruch zum Ausführen der Schritte des Verfahrens gemäß einem der Ansprüche 1 bis 7 veranlassen.

10. Per Computer lesbarer Träger, auf dem das Computerprogramm gemäß dem voranstehenden Anspruch gespeichert ist.

**Claims**

1. A method for determining a load-shedding capacity K of a building, said building comprising a heating system supplied with a power $P_{ch}$ and comprising a heating circuit, said heating system being configured to modulate the energy transmitted inside the building as a function of an internal temperature setpoint $T^*_{int}$ , the load-shedding capacity K being the reduction of the supply power $P_{ch}$ over a given period that it is possible to apply to a building without the internal temperature $T_{int}$ of the concerned building falling below a set minimum temperature $T^{lim}_{int}$ , the method comprising a step (E1) of determining an initial operation model of the building characterising the balance state of said building, taking the inertia $I_{bat}$ of said building into account; said method being **characterised in that** it comprises:

   - a step (E2) of disturbing the supply power $P_{ch}$ of the heating system of said building, the disturbance being induced by a modification in the temperature setpoint $T^*_C$ of the heating circuit including:

     ▪ a first substep (E21) of reducing the temperature setpoint $T^*_C$ during a first period;

     ▪ a second substep (E22) of reducing the temperature setpoint $T^*_C$ during a second period during which the internal temperature $T_{int}$ reaches a threshold temperature $T^{seuil}_{int}$ given by:

$$T_{int}^{seuil} = T_{ext} - \frac{f(T_c)P_{ch-nom}}{UA}$$

where $T_{ext}$ is the external temperature, $P_{ch-nom}$ is the rated power of the heating system, $f(T_c)$ is given by the following relationship:

$$f(T_c) = \frac{T_c - T_c^{min}}{T_c^{max} - T_c^{min}} \quad (6)$$

where $T_c$ is the temperature of the heating circuit, $T_C^{min}$ is the minimum value for the start temperature of the heating circuit and $T_C^{max}$ is the maximum value for the start temperature of the heating circuit and UA is the generalised loss coefficient of the building determined using the following relationship:

$$P_{ch} = UA(T_{int} - T_{ext})$$

considering that the internal temperature $T_{int}$ equal to the internal setpoint temperature $T_{int}^{*}$ during the rated operation of the heating system during which the heating power $P_{ch}$ develops so that the temperature $T_c$ of the heating circuit is constant and substantially equal to the setpoint temperature $T_c^{*}$ of said heating system while the external temperature $T_{ext}$ changes;
the reduction performed during the first reduction substep (E21) being lower than the reduction performed during the second reduction substep (E22);

- for each of the reduction substeps (E21, E22) and the disturbance step (E2), a step (E3) of measuring the response of said building to said disturbance comprising measuring the supply power $P_{ch}$ of the heating system during said disturbance;
- a step (E4) of determining parameters of the initial operation model of the building from the measurement of the response of said building, said determination being a function of the initial operation model of the building and including determining the thermal inertia of the building $I_{bat}$ by integrating the heating power $P_{ch}$ during the second reduction substep (E22) considering that the energy thus calculated is equal to $I_{bat}(T_{int}^{*} - T_{int}^{seuil})$ ;
- a step (E5) of determining a load-shedding capacity K of the building using the relationship $K = I_{bat}(T_{int} - T_{int}^{lim})$ assuming the internal temperature $T_{int}$ equal to the predetermined setpoint temperature $T_{int}^{*}$ .

2. The method according to the preceding claim, **characterised in that** the model determined during the step of determining an initial operation model of the building takes the power consumed for producing domestic hot water into account.

3. The method according to one of the preceding claims, **characterised in that** it comprises a step of updating the physical model, the step (E2) of disturbing the supply power $P_{ch}$ of the heating system, the step (E3) of measuring the response of said building to said disturbance, the step (E4) of determining parameters of the initial model and the step (E5) of determining the load-shedding capacity K of the building being implemented again during this update.

4. The method according to one of the preceding claims, **characterised in that** the generalised loss coefficient of the building is determined assuming the internal temperature $T_{int}$ equal to the setpoint temperature $T_{int}^{*}$ during the rated operation of the heating system during which the temperature $T_c$ of the heating circuit is constant and substantially equal to the setpoint temperature $T_C^*$ of said heating system.

5. A method for load-shedding a building, said building comprising a heating system supplied with a power $P_{ch}$, said method being **characterised in that** it comprises:

   - a step (F1) of implementing a method for determining the load-shedding capacity K of said building according to one of the preceding claims;
   - a step (F2) of determining optimum load-shedding setpoints from the previously determined load-shedding capacity;
   - a step (F3) of implementing said load-shedding setpoints by the heating system.

6. The method according to the preceding claims, **characterised in that** the method comprises, at the end of the second step of determining optimum load-shedding setpoints, a step of checking the load-shedding setpoints determined during the step (F2) of determining load-shedding setpoints.

7. The method according to the preceding claim, **characterised in that** the step of checking the load-shedding setpoints comprises:

   - a first substep of simulating the response of the building from said setpoints and the model of the building;
   - a second substep of checking the compliance of the obtained response of the building;
   - when the response does not comply, a third substep of correcting said setpoints.

8. A heating system (SYC) supplied with a power $P_{ch}$, **characterised in that** it comprises means configured to implement a method for determining a load-shedding capacity K of a building according to one of claims 1 to 4 or a method for load-shedding a building according to one of claims 5 to 7.

9. A computer program comprising instructions which cause the system according to the preceding claim to carry out the steps of the method according to one of claims 1 to 7.

10. A computer readable medium, on which the computer program according to the preceding claim is recorded.

T_ext  CONV  T_C*  REGUL  T_C

MT2

P'_CH

MT

CH  CC

Fig. 1

Fig. 2

Fig. 3

Fig. 4

Fig. 5

Fig. 6

Fig. 7

Fig. 8

Fig. 9

SYC

Fig. 10

Fig. 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2021696 A

**Littérature non-brevet citée dans la description**

- **BÂCHER et al.** Identifying suitable models for the heat dynamics of building. *Energy and buildings,* vol. 43 (7